Europäisches Patentamt

European Patent Office

Office européen des brevets

(11) Publication number: **0 466 238 A2**

# EUROPEAN PATENT APPLICATION

(21) Application number: **91201647.4**

(22) Date of filing: **27.06.91**

(51) Int. Cl.5: **H03K 17/16**

(30) Priority: **06.07.90 US 548788**

(43) Date of publication of application:
**15.01.92 Bulletin 92/03**

(84) Designated Contracting States:
**DE FR GB IT**

(71) Applicant: **N.V. Philips' Gloeilampenfabrieken**
**Groenewoudseweg 1**
**NL-5621 BA Eindhoven(NL)**

(72) Inventor: **Fletcher, Thomas Dale**
**c/o INT. OCTROOIBUREAU B.V. Prof.**
**Holstlaan 6**
**NL-5656 AA Eindhoven(NL)**
Inventor: **Burton, Edward Allyn**
**c/o INT. OCTROOIBUREAU B.V. Prof.**
**Holstlaan 6**
**NL-5656 AA Eindhoven(NL)**
Inventor: **Ma, Benny Tin-Hung**
**c/o INT. OCTROOIBUREAU B.V. Prof.**
**Holstlaan 6**
**NL-5656 AA Eindhoven(NL)**

(74) Representative: **Strijland, Wilfred et al**
**INTERNATIONAAL OCTROOIBUREAU B.V.**
**Prof. Holstlaan 6**
**NL-5656 AA Eindhoven(NL)**

(54) **Driver circuit.**

(57) In a driver circuit, high- and low-impedance drive means (26 and 28 respectively) operate in parallel to effect a desired output transition. Adaptive control means 32 respond to a threshold value of the output signal (VO) and turn off the low-impedance drive means in the course of the output transition. The low initial output impedance of the driver circuit effects rapid charging of a line capacitance CL, while toward the end of the output transition the higher output impedance of the driver circuit more closely matches the input impedance ZL of a load circuit. This higher impedance dampens ringing and thereby reduces induced suppy line noise which is conventionally associated with high-speed driver circuits.

FIG.6

Rank Xerox (UK) Business Services

EP 0 466 238 A2

The invention relates to a driver circuit for causing a desired output transition in an output signal in response to a corresponding input transition in an input signal. The invention further relates to an integrated circuit comprising the driver circuit.

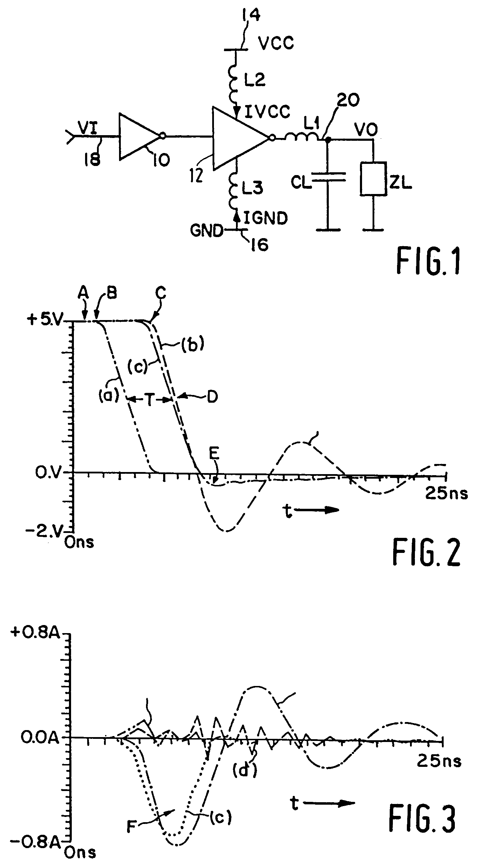

Such driver circuits are used in low power digital circuits, in particular integrated circuits, to interface to higher power circuitry, or via interconnections to circuitry on another circuit board, another integrated circuit chip, or even within the same chip. The effective load is therefore typically characterized by a load circuit impedance ZL in parallel with a large capacitance CL of the interconnections, as illustrated at the output of a conventional driver circuit in Figure 1. The circuit of Figure 1 may be constructed for example in complementary MOS (CMOS) technology. Two inverters 10 and 12 in cascade form the driver circuit, receiving an input signal VI on an input line 18 and generating a corresponding output signal VO across the load on an output line 20.

Figure 2, curve (a) shows a high-to-low transition in the input signal VI while Figure 2, curve (b) shows the output transition in VO which results after a few nanoseconds propagation delay. In order that the output transition may occur at high speed, the inverter 12 is constructed using large transistors to give the circuit a low output impedance so that it may discharge the capacitance CL rapidly. Unfortunately, the line capacitance CL and inductances L1-L3 in the output line 20 and the supply lines 14 (VCC) and 16 (GND) respectively form a resonant circuit, and the low output impedance enables the output signal VO to overshoot the desired low level (GND) and to continue "ringing" (oscillating around the desired level) for several cycles. This ringing is a noise source which can lead to spurious transitions being detected by the load circuit and by nearby circuits connected to the same supply lines. Consequently, the designer of a conventional driver circuit is forced to accept a compromise between switching speed and switching noise.

In Figure 3, curve (a) illustrates the ground supply current IGND drawn by the inverter 12 from the supply line 16 (GND) during the transition. In addition to a large peak of current (at F) required to discharge the load capacitance, the ringing is reflected in a series of peaks in the current IGND, which represent a considerable waste of power (generating heat), as well as being a source of noise. Figure 3, curve (b) shows the supply current IVCC drawn from the positive supply VCC. This current IVCC is not large during the high-to-low output transition illustrated, but in the case of the complementary (low-to-high) transition, the roles of IVCC and IGND will be substantially reversed.

The problem of switching noise in outputs and supply lines is a general one, but is particularly acute in circuit technologies such as CMOS, where the output driving is provided by insulated gate field effect transistors (including, for example, MOS transistors). Such devices when turned on act very much like simple resistors, lacking the rectifying properties of bipolar transistors.

It is an object of the invention to enable the provision of a driver circuit allowing high speed operation without a corresponding increase in noise.

The invention provides a driver circuit for causing a desired output transition in an output signal in response to a corresponding input transition in an input signal, characterized in that the circuit comprises adaptive control means for varying an output impedance of the driver circuit adaptively in response to the output signal as the output transition progresses. By using feedback of the actual output signal value to modify the output impedance of the driver circuit during the transition, the various parameters of speed, noise, power dissipation and so forth can be improved without the compromises that are a feature of conventional driver circuits.

For example, the adaptive control means may be arranged to increase the output impedance as the output transition progresses. A low initial output impedance provides fast charging of the load capacitance, while a higher impedance towards the end of the transition helps to dampen ringing. Thus higher speed can be achieved without the corresponding increase in noise associated with conventional circuits.

Such a driver circuit may comprise first and second drive means responsive to the input signal, while the adaptive control means comprise means for deactivating the second drive means in response to the output signal crossing a threshold value in the course of the output transition. This provides a simple embodiment, particularly suitable for implementation in CMOS technology.

The first and second drive means may comprise high- and low-output impedance drive means respectively. The second drive means, or both in parallel, can be optimized to effect rapid charging of the line capacitance, while the output impedance of the first drive means can be adapted to that of the load circuit so as to reduce ringing.

It may be noted that United States Patent 4,421,994 provides a driver circuit in which a low impedance drive means is activated to achieve fast transition and then deactivated after a short delay. It should be appreciated, however, that in that earlier circuit the delay is fixed at a value which is guaranteed to exceed the time taken for the output transition. The sole aim of this measure in the circuit of US 4,421,994 is to limit the power dissipation to a safe level in the event of a short circuit at the output of the driver. The problems of impedance mismatch and noise are not addressed, and feedback of the actual output signal to control output impedance during the transition is not countenanced.

The adaptive control means may comprise a transmission gate for coupling the input signal to the second drive means and adaptive delay means for coupling the input signal to a gating input of the transmission gate in response to the output signal crossing the threshold value. In such an embodiment the first drive means may also form the adaptive delay means.

A second drive means may comprise a transistor having its main current path connected between a supply terminal and an output terminal of the driver circuit, which output terminal carries the output signal, and clamping means may be arranged to turn off the transistor actively in response to the output signal crossing said threshold value. The output impedance due to the second drive means can be set to a desired value by choosing suitable dimensions for the transistor.

The first and/or the second drive means may comprise distributed drive means whereby at least a part of the drive means is activated with a small delay so as to reduce the rate of change of a current flowing in the circuit during the output transition. This measure can reduce the level of noise caused by supply line inductances.

The driver circuit may further comprise complementary drive means for effecting a complementary output transition of the output signal in a direction opposite to that of the first mentioned output transition. The complementary drive means may also feature adaptive impedance control by means similar to those described above, if desired. The impedances, threshold values and other parameters can be made the same or different in the different transition directions, to suit the line and load impedances.

Embodiments of the invention will now be described, by way of example, with reference to the accompanying drawings, in which:

Figure 1 shows in block schematic form a conventional driver circuit and typical load for such a circuit;

Figure 2 shows input and output voltages of the conventional driver of Figure 1 and a driver circuit embodying the invention in the course of a single transition;

Figure 3 shows supply current variations for the conventional driver of Figure 1 and the driver circuit embodying the invention during the same transition;

Figure 4 shows in block schematic form a bidirectional driver circuit embodying the invention;

Figure 5 defines the symbol for a transmission gate as used in Figures 6 and 7;

Figure 6 shows in schematic form a first detailed embodiment of the driver circuit of Figure 4; and

Figure 7 shows in schematic form a second detailed embodiment of the driver circuit of Figure 4.

The driver circuit of Figure 1, and the signals represented in Figure 2, curves (a) and (b) and Figure 3, curves (a) and (b) have already been described above and identified as belonging to the prior art.

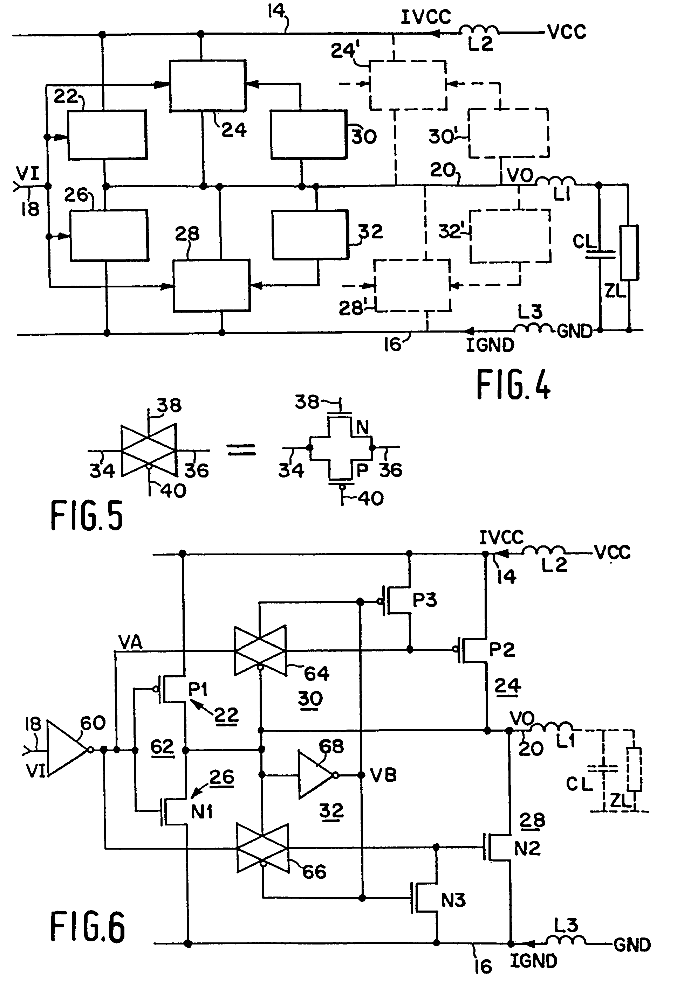

Figure 4 shows in block schematic form a driver circuit incorporating adaptive control of its output impedance, for use in place of the conventional driver circuit of Figure 1. Power supply lines 14 and 16 are provided to receive the supply voltages VCC and GND respectively, while input and output lines 18 and 20 respectively carry the input signal VI and the output signal VO respectively. First and second high-side drive means 22 and 24 are connected in parallel between the supply line 14 (VCC) and the output line 20 (VO) and each has a control input connected to the input line 18 (VI). First and second low-side drive means 26 and 28, complementary to the high-side drive means, are connected in parallel between the output line 20 (VO) and the GND line 16, and each similarly has a control input connected to the input line 18 (VI).

A high-side feedback device 30 has an input connected to the output line 20 (VO) and an output connected to a further control input of the second high-side drive means 24, while a low-side feedback device 32 has an input connected to the output line 20 and an output connected to a further control input of the second low-side drive means 28. Each feedback device 30 and 32 embodies adaptive control means for the high-side and low-side drive means, respectively.

In operation, each of the drive means 22 to 28 may be considered as a switch which will be open or closed depending on the logical value of the input signal VI which is applied to its control input. Assuming that a non-inverting driver circuit is desired, the high-side switches 22 and 24 will close when VI goes high (towards VCC), thereby connecting the output line 20 (VO) to VCC. The low-side switches 26 and 28, on the other hand, will close when VI goes low (towards GND), thereby connecting the output line 20 (VO) to GND. Each switch has a characteristic impedance when closed, which may be referred to as its on-resistance RON.

When both high-side switches 22 and 24 are on (closed), and low-side switches 26 and 28 are off (open), then the output impedance of the driver circuit is the value of RON(22) in parallel with RON-

(24), represented herein as RON(22)‖RON(24). The first high-side switch 22 remains on at all times when VI is high, but the high-side feedback device 30 is able, via the further control input of the second high-side switch 24, to override the effect of VI and turn off the switch 24 in response to changes in the output signal VO. When this happens, the output impedance of the driver circuit is increased to RON(22). In a similar manner, when VI is low, the low-side feedback device 32 is able to turn off the second low-side switch 28, thereby increasing the output impedance of the circuit from RON(26)‖RON(28) to RON(26).

Therefore the circuit of Figure 4 can be designed to alter its own output impedance between at least two different values depending on the actual value of the output signal VO. A particular application of this ability is in driving the type of load identified in the introduction in which a large line capacitance CL appears in parallel with a load circuit impedance ZL.

Consider for the sake of example a high-to-low transition as described above for the conventional driver with reference to Figures 2 and 3. In the circuit of Figure 4, RON(26) can be made a relatively high impedance to match ZL, while RON(28) can be such that RON(26)‖RON(28) is a low value optimized for rapid discharging of the line capacitance CL from VCC towards GND. If the low-side feedback device 32 is designed to respond to a certain threshold value of VO somewhere between VCC and GND, then the following sequence of events will ensure that VO follows the graph of curve (c) in Figure 2.

At time A, before the transition begins, the high impedance high-side switch 22 is held on by the input signal VI being high, while the low-side switches 26 and 28 are held off. The line capacitance CL and the load circuit impedance ZL are charged to VCC and output signal VO is high. The low impedance high-side switch 24 is therefore held off by feedback device 30.

The high-to-low input transition begins at B, and, after a propagation delay T, the low-side switches 26 and 28 are turned on by the low value of VI while the high-side switch 22 is turned off. This low impedance connection to GND begins the rapid discharge of the line capacitance CL, and so the output signal VO begins its downward transition at C.

At D, the output signal VO reaches the threshold value required to activate the low-side feedback device 32, and the low impedance low-side switch 28 is turned off again. By this time, the line capacitance CL is substantially discharged, and the transition is completed by the high impedance switch 26 alone. Since RON(26) is matched more closely to the load circuit impedance ZL, approximately critical damping is effected rather than the underdamping present in the conventional driver. The output signal VO therefore settles quickly to the desired value (GND in this example) with only minimal overshoot (at E) and no ringing. Figures 3-(c) and (d) show the variations of IVCC and IGND respectively during the course of the transition just described. It can be seen that the main peak in IGND (at F) has an area less than that for the known circuit (Figure 3, curve (a)). Since the output transition is achieved at least as quickly as by the known circuit, this indicates a more efficient use of power. Also, the subsidiary peaks in IGND are virtually absent due to successful damping out of the ringing.

The threshold value of VO at D can be chosen to suit the circumstances, in particular it is generally desirable that VO should have reached any input threshold value of the load circuit before the low impedance switch turns off, to ensure that the information represented by the transition is received reliably.

The operation of the circuit in the case of a subsequent low-to-high transition will be exactly as described above, but with the roles of the high-side elements (22, 24, 30) and the low-side elements (26, 28, 32) reversed. The threshold value for the high-side feedback device 30 need not be the same as that for the low-side feedback device 32.

Figure 4 also shows in broken lines further high-side and low-side drive means 24' and 28', each with an associated feedback device 30' or 32'. In principle, any number of drive means can be connected in parallel and activated or deactivated by feedback devices in the course of the output transition, thereby achieving an output impedance which is a more complex function of VO than the simple two-value function described above. In alternative embodiments, a single drive means may have its on-resistance continuously modulated by feedback of the output signal. Indeed, the ideal on-off switch can never be realised, so that some intermediate values of output impedance will always be passed through in the course of transition.

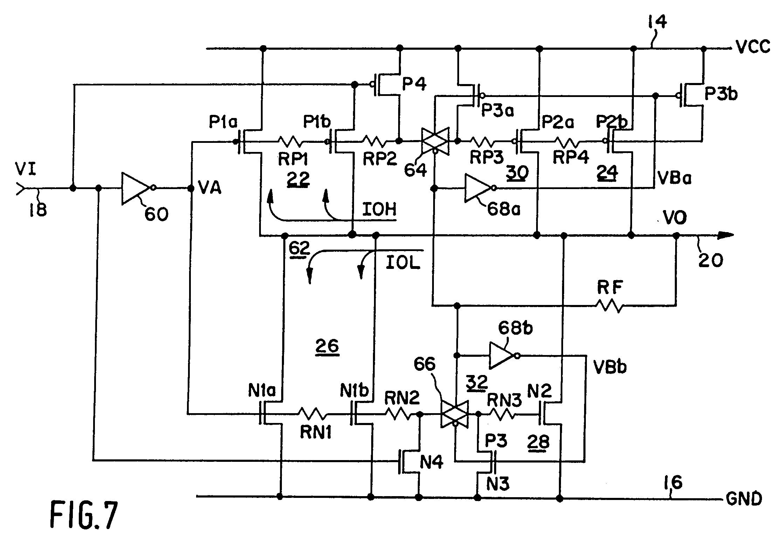

Figure 5 shows on the left a symbol for a transmission gate which is used in the embodiments of Figures 6 and 7. A CMOS circuit for a transmission gate is shown on the right hand side of Figure 5. All transistors used in this embodiment are enhancement mode insulated gate field-effect transistors, such as MOS transistors. An n-channel transistor N and a p-channel transistor P are connected with their main current paths in parallel between two main terminals 34 and 36 of the transmission gate. The gates of N and P form complementary gating inputs 38 and 40 of the transmission gate respectively. Signals can be conducted (transmitted) in either direction between the terminals 34 and 36, or else blocked, depending on signals applied to the gating inputs 38 and 40 of the transmission gate. In general, complementary signals will be applied to the gating inputs 38 and 40. When input 38 is low and input 40 is high, both transistors N and P will be on, conducting signals bidirectionally between terminals 34 and 36. In the reverse situation, when input 38 is high and input 40 is low, both transistors N and P will be off, blocking the passage of signals between terminals 34 and 36. The gating inputs 38 and 40 of a transmission gate will be referred to herein as the N and P gating inputs respectively, with the P gating input 40 being marked by a circle in the symbol shown in Figure 5.

Figure 6 shows a first practical embodiment of the circuit of Figure 4, constructed for the sake of example using MOS transistors. The reference signs used in Figures 6 and 7 correspond as far as possible with those used in Figure 4. First and second high-side drive means 22 and 24 are formed by first and second p-channel transistors P1 and P2, respectively, connected between the supply line 14 (VCC) and the output line 20 (VO). First and second low-side drive means 26 and 28 are formed by first and second n-channel transistors N1 and N2, respectively, connected between the supply line 16 (GND) and the output line 20 (VO). The transistors P2 and N2 are constructed with wider channels than the transistors P1 and N1, so as to have lower on-resistances than those other transistors.

An inverter 60 has an input connected to the input line 18 (VI) and has an output (VA) connected directly to the gates of the high impedance transistors P1 and N1. The output (VA) of the input inverter 60 is also connected via a first transmission gate 64 to the gate of the low impedance p-channel transistor P2, and via a second transmission gate 66 to the gate of the low impedance n-channel transistor N2. The output line 20 (VO) is connected to the P gating input of the first transmission gate 64 and also to the N gating input of the second transmission gate 66. A further inverter 68 has an input also connected to the output line 20 (VO) and has an output (VB) connected to the N gating input of the first transmission gate 64 and also to the P gating input of the second transmission gate 66.

A p-channel clamping transistor P3 connects the supply line 14 (VCC) to the gate of the low impedance p-channel transistor P2. An n-channel clamping transistor N3 connects the supply line 16 (GND) to the gate of the low impedance n-channel transistor N2. The gates of the clamping transistors P3 and N3 are connected to the output (VB) of the further inverter 68.

The elements of the Figure 6 circuit correspond closely to those in Figure 4, except that the further inverter 68 forms part of the feedback devices both for high-side (30) and low-side (32). The complementary transistor pair P1/N1 forms a conventional CMOS inverter 62, so that by virtue of the input inverter 60, the driver circuit as a whole has a non-inverting function. Considering again the high-to-low transition illustrated in Figure 2, curves (a) (VI) and (c)(VO), and bearing in mind the principles of operation already described with reference to Figure 4, the operation of the driver circuit of Figure 6 can be described as follows.

In the steady state before the input transition (A, Figure 2), VI is high (VCC) so that VA at the output of the input inverter 62 is low (GND). The high impedance transistors P1 and N1 are on and off respectively, so that VO is high and VB at the output of the further inverter 68 is low. The first transmission gate 64 is therefore blocking, and the p-channel clamping transistor P3 is on, ensuring that the low-impedance p-channel transistor P2 is off. The second transmission gate 66 is conducting the low value of VA to the gate of low impedance transistor N2, which is therefore off. The n-channel clamping transistor N3 is also off.

Immediately following the input transition (B in Figure 2), VI is low and VA goes high. This causes the high impedance p-channel transistor P1 to turn off and the corresponding n-channel transistor N1 to turn on, but the output signal VO remains high due to the line capacitance CL. The second transmission gate 66 remains conducting and VA (high) is applied to the gate of the low impedance n-channel transistor N2, turning it on. The n-channel transistors N1 and N2 therefore work in parallel to begin the rapid discharging of the line capacitance CL, so that VO begins to fall towards GND.

A certain threshold value of VO is determined by the supply voltage VCC and the threshold voltages of the transistors in the second transmission gate 66 and in the further inverter 68. These threshold voltages can be set as desired by varying the dimensions of the transistors in a manner well known to those skilled in the art. As VO crosses this threshold, the state of the transmission gate 66 and the further inverter 68 will change so that the gate 66 becomes blocking and VB at the output of the inverter 68 becomes high. As a result, the low impedance transistor N2 can no longer be turned on by the signal VA, and furthermore the clamping transistor N3 gets turned on by VB and ensures rapid turn off of the low impedance transistor N2 before VO reaches GND. Thereafter, only the high impedance transistor N1 is driving the output line 20 (VO), so that VO settles without ringing to the desired value GND.

The first transmission gate 64 also changes state to become conducting as VO crosses the threshold. The low impedance p-channel transistor P2 therefore remains turned off throughout the high to low transition: initially because clamping transistor P3 is on and later because the high value of VA is conducted to the gate of transistor P2 by the first transmission gate 64. In response to a subsequent low-to-high input transition, the desired output transition is effected by the high-side elements P1, P2, P3 and 64 in a manner complementary to that described above in relation to the low-side elements N1, N2, N3 and 66 during the high-to-low transition.

The signal values indicated in Figure 2, curve (c), and Figure 3, curves (c) and (d) represent the values of VO, IGND and IVCC in a typical circuit according to Figure 6, when operating from a supply voltage VCC of 5 volts and driving a line capacitance CL of approximately 50 picofarads. The threshold-to-threshold propagation delay T is approximately 3ns, and the output transition time is also approximately 3ns.

The load circuit impedance ZL in the example presented in Figures 2 and 3 is substantially infinite (dc value). This is typical for example when the load circuit is a CMOS or mixed bipolar-CMOS (BiCMOS) circuit. Consequently the steady state values of IGND and IVCC are substantially zero. This will not be the case for all circuit technologies. For example a driver circuit for a TTL input may need to supply several milliamps through the output line 20 in the low steady state. The high impedance transistors P1 and N1 should in such a case have an on-resistance low enough to meet the current requirements of the load circuit represented by ZL.

The second practical embodiment illustrated in Figure 7 is a modification of the embodiment of Figure 6, as will be apparent to the reader skilled in the art. The same reference signs are used in Figure 7 as in the earlier figures, to the extent possible, and the following description will be limited to the points of distinction between the two embodiments.

In the embodiment of Figure 7, the first high-side drive means 22 formed in Figure 6 by transistor P1 has been divided into two parallel transistors P1a and P1b. Similarly, the second high-side drive means 24 (transistor P2) has been divided into transistors P2a and P2b, while the first low-side drive means 26 (transistor N1) has been divided into transistors N1a and N1b. The second low-side drive means 28 remains a unitary transistor referenced N2.

The gates of the p-channel transistors P2a and P2b receive signal VA via the transmission gate 64 as before. Additionally, however, the gates of transistors P1b, P2a and P2b are separated from one another and from the transmission gate 64 by a chain of resistors RP1 to RP4 as shown in Figure 7. Similarly, the gates of transistors N1a, N1b and N2 are separated from one another and from the transmission gate 66 by a chain of resistors RN1 to RN3. It should be noted that in modern CMOS-type circuit technologies the gates of the transistors are made of polysilicon instead of metal. In that case, the gates and resistors can be made conveniently using a single pattern of polysilicon and each gate will in itself form a distributed resistor. The discrete resistors shown in Figure 7 are to this extent only approximations to the distributed resistances in a physical embodiment.

Each resistor RP1, RP2/RP3, RP4, RN1 and RN2/RN3 forms an R-C delay element with the gate capacitance of a respective transistor. Therefore, in response to a high-to-low input transition, the transistors N1a, N1b and N2 turn on sequentially, each following the preceding one after a short delay. Similarly, in the case of a low-to-high transition, the transistors P1a, P1b, P2a and P2b turn on sequentially, rather than simultaneously. The effect of turning on a plurality of parallel driver transistors sequentially rather than simultaneously is to reduce the instantaneous rate of change of current (dI/dt) flowing in the supply lines 14, 16 and the output line 20. This leads to a proportional reduction in the noise voltages induced in the inductances L of those lines. The resistor values are chosen to make the R-C delays smaller than the transition time. For example, the circuit of Figure 7 may be used to drive a line capacitance of 150 picofarads with a typical transition time of 10 ns, while the R-C delays are such that all of the transistors P1a, P1b, P2a and P2b turn on within two or three nanoseconds.

When the threshold of the output signal VO is crossed, it is desirable that the transistors P2a and P2b should turn off without such a delay. The clamping transistor P3 is for this purpose divided into two clamping transistors P3a and P3b. The transistor P2b is turned off by transistor P3b acting directly on its gate, while the transistor P2a is turned off quickly by transistors P3a and P3b acting in parallel via resistors RP3 and RP4 respectively.

The embodiment of Figure 7 can be made suitable for driving a TTL-compatible load circuit (ZL). In such an application, the impedances of the transistors N1a and N1b which form the first low-side drive means 26 will need to be made low enough that a steady state output current IOL (VO low) or 2 or more milliamps can be supplied. Other applications, for example in bus driving, may also require substantial steady state currents in one or both states. Additional clamping transistors P4 and N4 receive the input signal VI and act on the gates of the transistors P1b and N1b respectively. Since the steady state output currents IOL (VO low) and IOH (VO high) may be substantial, these clamping transistors P4 and N4 act via the resistors RP2 and RN2 respectively so that the transistor P1b or N1b turns off rapidly in the event of a transition, but not exactly at the same time as the corresponding transistor P1a or N1a respectively. In this manner, dI/dt noise may be further reduced. A further point of difference from the embodiment of Figure 6 is that the output line 20 is connected to the gating inputs of the transmission gates via an electrostatic discharge (ESD) protection device, including a resistor RF. The resistance of the resistor RF is low, for example 800 ohms, and may be regarded as a short circuit for the purposes of this description.

A yet further point of difference is that the output signal VO fed back via the resistor RF is supplied in parallel to the inputs of two inverters 68a and 68b, in place of the single inverter 68 provided in Figure 6. The output (VBa) of inverter 68a is connected to the N gating input of the first transmission gate 64 and to the gates of the p-channel clamping transistors P3a and P3b. The output (VBb) of inverter 68b is connected to the P gating input of the second transmission gate 66 and to the gate of the n-channel clamping transistor N3. The sequence of operation of the circuit is the same as described above with reference to Figure 6, except that the threshold for deactivation of the second high-side drive means 24 (P2a/P2b) in the course of a low-to-high transition and the threshold for deactivation of the second low-side drive means 28 (N2) in the course of a high-to-low transition can be made to be different by using different transistor dimensions in the transmission gates 64 and 66 and in the two inverters 68a and 68b.

In particular, the TTL-compatible load circuit being driven will typically have input threshold voltages VIH = 2.4 volts (minimum) and VIL = 0.4 volts (maximum). In that case, it is desirable that the threshold of inverter 68a should be at least 2.4 volts above GND, while the threshold of inverter 68b should be no more than 0.4 volts above GND, if possible. Further variations may be apparent to the skilled reader.

**Claims**

1. A driver circuit for causing a desired output transition in an output signal in response to a corresponding input transition in an input signal, characterized in that the circuit comprises adaptive control means for varying an output impedance of the driver circuit adaptively in response to the output signal as the output transition progresses.

2. A driver circuit as claimed in Claim 1 wherein the adaptive control means are arranged to increase the output impedance as the output transition progresses.

3. A driver circuit as claimed in Claim 2 wherein the circuit comprises first and second drive means responsive to the input signal and wherein the adaptive control means comprise means for deactivating the second drive means in response to the output signal crossing a threshold value in the course of the output transition

4. A driver circuit as claimed in Claim 3 wherein the first and second drive means comprise high- and low-output impedance drive means respectively.

5. A driver circuit as claimed in Claim 3 wherein the adaptive control means comprise;
   - a transmission gate for coupling the input signal to the second drive means; and
   - adaptive delay means for coupling the input signal to a gating input of the transmission gate in response to the output signal crossing the threshold value.

6. A driver circuit as claimed in Claim 5 wherein the first drive means also form the adaptive delay means.

7. A driver circuit as claimed in Claim 3 wherein:
   - the second drive means comprise a transistor having its main current path connected between a supply terminal and an output terminal of the driver circuit, which output terminal carries the output signal; and
   - clamping means are arranged to turn off the transistor actively in response to the output signal crossing said threshold value.

8. A driver circuit as claimed in Claim 3 wherein at least one of the first and second drive means comprise distributed drive means whereby at least a part of the drive means is activated with a small delay so as to reduce the rate of change of an current flowing in the circuit during the output transition.

9. A driver circuit as claimed in Claim 1 further comprising complementary drive means for effecting a complementary output transition of the output signal in a direction opposite to that of the first mentioned output transition.

10. A driver circuit as claimed in Claim 9 when constructed using complementary insulated gate transistors in a CMOS circuit configuration.

11. A driver circuit as claimed in Claim 3 wherein the second drive means comprise an insulated gate field-effect transistor.

12. A driver circuit as claimed in Claim 4 wherein the first and second drive means comprise insulated gate field-effect transistors of different channel dimensions.

13. An integrated circuit comprising at least one driver circuit as claimed in any of the previous Claims.

FIG.1

FIG.2

FIG.3

FIG.4

FIG.5

FIG.6

FIG.7

EP 0 466 238 A2